# EUROPEAN PATENT APPLICATION

(11) **EP 2 562 869 A1**
(43) Date of publication of application: **27.02.2013**
(21) Application number: 11190388.6
(22) Date of filing: 23.11.2011
(51) Int. Cl.: H01Q 1/24, H01Q 1/38, H01Q 1/44, H01Q 9/04, H01L 31/0224, H01L 31/042

(54) **Antenna structure**

(30) Priority: 25.08.2011 TW 100130435
(71) Applicant: Industrial Technology Research Institute, Hsinchu 31040 (TW)
(72) Inventor: Pu, Ta Chun, Kaohsiung City 806 (TW); Wu, Chun Yih, Taipei City 110 (TW); Chen, Jui Hung, Taichung City 414 (TW); Lin, Hung Hsuan, Hsinchu County 302 (TW)
(74) Representative: 2K Patentanwälte Blasberg Kewitz & Reichel

(57) **Abstract**

An antenna structure comprises a substrate (11) having a first surface (11A) and a second surface (11B), an array of conductor units (13) positioned on the first surface and including at least two conductor units (15) which are coupled, and at least one load metal sheet (21) positioned on at least one of the first surface or the second surface. Each of the conductor units includes an intervening material (18) with two conductors (17,19) positioned on opposite surfaces of the intervening material.

## Description

### BACKGROUND

### 1. Technical Field

The present disclosure relates to an antenna structure, and more particularly, to an antenna structure using multiple conductor units and load metal sheets to excite radiation modes.

### 2. Background

Due to the urgent need to adopt alternative energy sources, solar industries are growing and receiving governmental support. Along with the increase of the solar cell PV conversion efficiency, PV modules are gradually moving from large area installments for green energy generation to charging modules for hand-held mobile devices providing immediate power supply and longer operation time. In order to provide hand-held mobile devices with sufficient electric power supply, the charging module has to reserve an area for PV conversion use. Utilizing the electrodes of the charging module as a portion of the antenna radiation metal sheet can provide low frequency RF current paths and increase radiation efficiency in hand-held mobile devices. After integrating, the charging module can be used as a main antenna or a diversity antenna in mobile devices, and the two categories can both add value to the charging module. In order to effectively excite the antenna modes without reducing PV conversion efficiency under a fixed PV module area, special techniques are required to achieve this goal.

### SUMMARY

The present application discloses an antenna structure, comprising a substrate which has a first surface and a second surface; an array of conductor units positioned on the first surface and including at least two conductor units which are coupled, wherein each conductor unit includes an intervening material and two conductors, and the two conductors are positioned on opposite surfaces of the intervening material; and at least one load metal sheet positioned on the first surface, on the second surface, or on the first surface and the second surface.

The foregoing has outlined rather broadly the features and technical advantages of the present application in order that the detailed description of the application that follows may be better understood. Additional features and advantages of the application will be described hereinafter, and form the subject of the claims of the application. It should be appreciated by those skilled in the art that the conception and specific embodiment disclosed may be readily utilized as a basis for modifying or designing other structures or processes for carrying out the same purposes of the present application. It should also be realized by those skilled in the art that such equivalent constructions do not depart from the spirit and scope of the application as set forth in the appended claims.

### BRIEF DESCRIPTION OF THE DRAWINGS

The objectives and advantages of the present application are illustrated with the following description and upon reference to the accompanying drawings in which:
- FIG. 1: illustrates an antenna structure according to one embodiment of the present application;
- FIG. 2: illustrates an antenna structure according to another embodiment of the present application;
- FIG. 3: illustrates an antenna structure according to another embodiment of the present application;
- FIG. 4: illustrates an antenna structure according to another embodiment of the present application;
- FIG. 5: illustrates an antenna structure according to another embodiment of the present application;
- FIG. 6: illustrates an antenna structure according to another embodiment of the present application;
- FIG. 7: illustrates the structure of a conductor unit according to one embodiment of the present application;
- FIG. 8: illustrates the structure of a conductor unit according to another embodiment of the present application;
- FIG.9: illustrates the structure of a conductor unit according to another embodiment of the present application;
- FIG. 10: is a 3-dimensional diagram illustrating an antenna structure according to one embodiment of the present application;
- FIG. 11: is a local enlargement of the antenna structure 10G shown in FIG. 10;
- FIG. 12: is a local enlargement of the antenna structure 10G shown in FIG. 10;
- FIG. 13: illustrates an antenna structure according to another embodiment of the present application;
- FIG. 14: illustrates a simulation diagram of the antenna gain derived from the antenna structure shown in FIG. 13;
- FIG. 15: illustrates an antenna structure according to another embodiment of the present application;
- FIG. 16: illustrates a simulation diagram of the antenna gain derived from the antenna structure shown in FIG. 15;
- FIG. 17: illustrates an antenna structure according to another embodiment of the present application;
- FIG. 18: illustrates a simulation diagram of the antenna gain derived from the antenna structure shown in FIG. 17;
- FIG. 19: illustrates an antenna structure according to another embodiment of the present application;
- FIG. 20: illustrates a simulation diagram of the return loss derived from the antenna structure shown in FIG. 19;
- FIG. 21: illustrates an antenna structure according to another embodiment of the present application;
- FIG. 22: illustrates a simulation diagram of the return loss derived from the antenna structure shown in FIG. 21;
- FIG. 23: illustrates an antenna structure according to another embodiment of the present application;
- FIG. 24: illustrates a simulation diagram of the return loss derived from the antenna structure shown in FIG. 23;
- FIG. 25: illustrates an antenna structure according to another embodiment of the present application;
- FIG. 26: illustrates a simulation diagram of the return loss derived from the antenna structure shown in FIG. 25;
- FIG. 27: illustrates an antenna structure according to another embodiment of the present application;
- FIG. 28: illustrates a simulation diagram of the return loss derived from the antenna structure shown in FIG. 27;
- FIG. 29: illustrates an antenna structure according to another embodiment of the present application;
- FIG. 30: illustrates a simulation diagram of the return loss derived from the antenna structure shown in FIG. 29;
- FIG. 31: illustrates an antenna structure according to another embodiment of the present application; and
- FIG. 32: illustrates a simulation diagram of the return loss derived from the antenna structure shown in FIG. 31.

### DETAILED DESCRIPTION

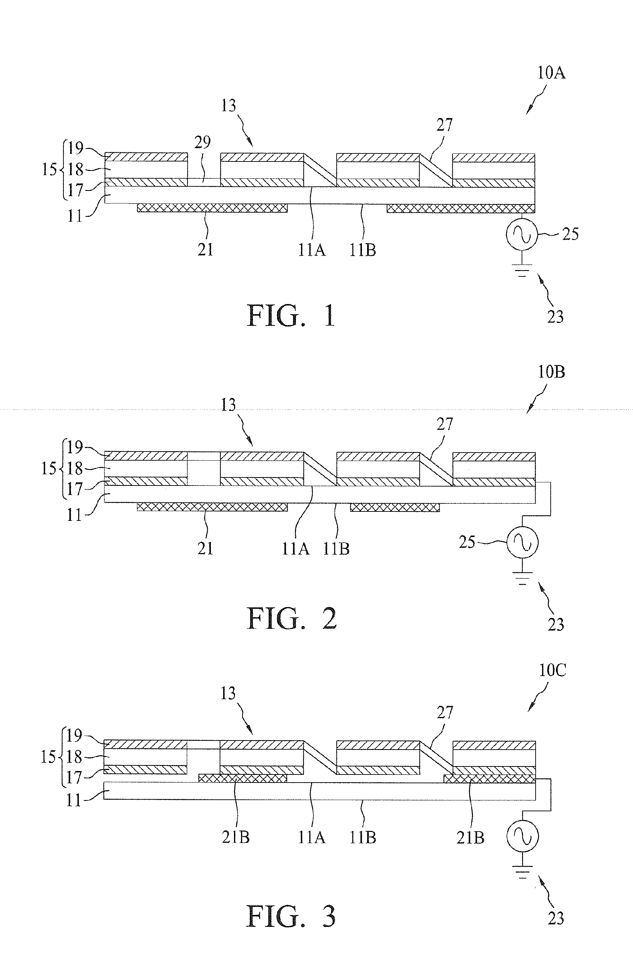

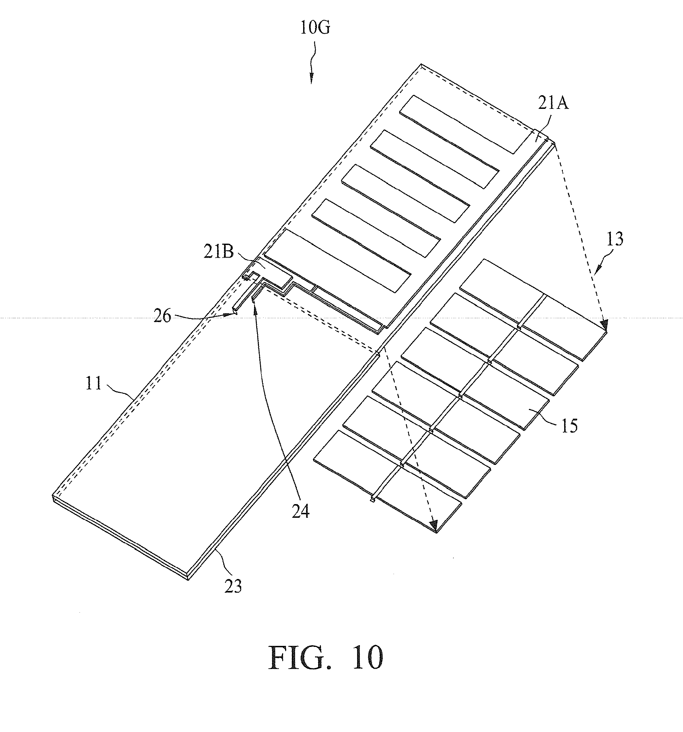

FIG. 1 illustrates an antenna structure 10A according to one embodiment of the present application. The antenna structure 10A comprises a substrate 11 having a first surface 11A and a second surface 11B; an array of conductor units 13 positioned on the first surface 11 A and including at least two conductor units 15 which are coupled; and at least one load metal sheet 21 positioned on the second surface 11 B and configured to be DC open with the conductor of the conductor unit 15; wherein a grounded end can be implemented as a ground metal sheet 23, which is positioned on the surface opposite from the surface on which the load metal sheet 21is positioned and the ground metal sheet 23 is configured to be DC open to the load metal sheet 21 (referring to FIG. 10), wherein an excitation source 25 is connected between the load metal sheet 21 and the ground metal sheet 23. In one embodiment of the present application, the partial portion of the load metal sheet 21 can overlap the vertical projection of the gap between conductor units 15.

In one embodiment of the present application, each of the conductor units 15 comprises an intervening material 18, a bottom conductor 17, and an upper conductor 19; wherein the bottom conductor 17 and the upper conductor 19 are disposed on the bottom surface and upper surface of the intervening material 18, respectively. The array of conductor units 13 is configured to either connect a bottom conductor 17 of one conductor unit 15 and an upper conductor 19 of the adjacent conductor unit 15 via a conducting piece 27, or connect bottom conductors 17 or upper conductors 19 of two adjacent conductor units 15 via a conducting piece 29. The coupling of the electromagnetic power between conductor units 15 can excite radiation modes of the array of conductor units 13, and the load metal sheet 21 can excite radiation modes in a specific frequency range via the parasitic effect between itself and the array of conductor units 13. In one embodiment of the present application, the conductor unit 15 is smaller than one-quarter of a wavelength of a first operation mode of the antenna structure 10A, and the separation between adjacent conductor units 15 is smaller than 10mm.

In one embodiment of the present application, the conductor unit 15 is a photovoltaic conversion unit, wherein the intervening material is a material adopted in photovoltaic conversion, such as single crystal or poly crystal silicon. The bottom conductor 17 and the upper conductor 19 of the conductor unit 15 are two conducting electrodes of the photovoltaic conversion unit, and the configuration of the two photovoltaic conversion units, i.e. parallel or serial, is determined by the conducting piece 27 and the conducting piece 29. The photovoltaic conversion material transforms light energy to electrical energy, collecting and conducting the electrical energy coming from the other photovoltaic conversion units to the electric system via conducting electrodes.

FIG. 2 illustrates an antenna structure 10B according to another embodiment of the present application. The excitation source 25 of the antenna structure 10B is connected between the bottom conductor 17 of the conductor unit 15 and the ground metal sheet 23, in contrast to the antenna structure 10A shown in FIG. 1, in which the excitation source 25 of the antenna structure 10A is connected between the load metal sheet 21 and the ground metal sheet 23.

FIG. 3 illustrates an antenna structure 10C according to another embodiment of the present application. The load metal sheet 21 of the antenna structure 10C is positioned between the substrate 11 and the array of conductor units 13; in other words, the load metal sheet 21 is disposed on the first surface 11A, in contrast to the antenna structure 10A shown in FIG. 1, in which the load metal sheet 21 of the antenna structure 10A is positioned on the second surface 11B. In the antenna structure 10C, the load metal sheet 21 and the bottom conductor 17 of the conductor unit 15 are in direct contact and configured to be DC short.

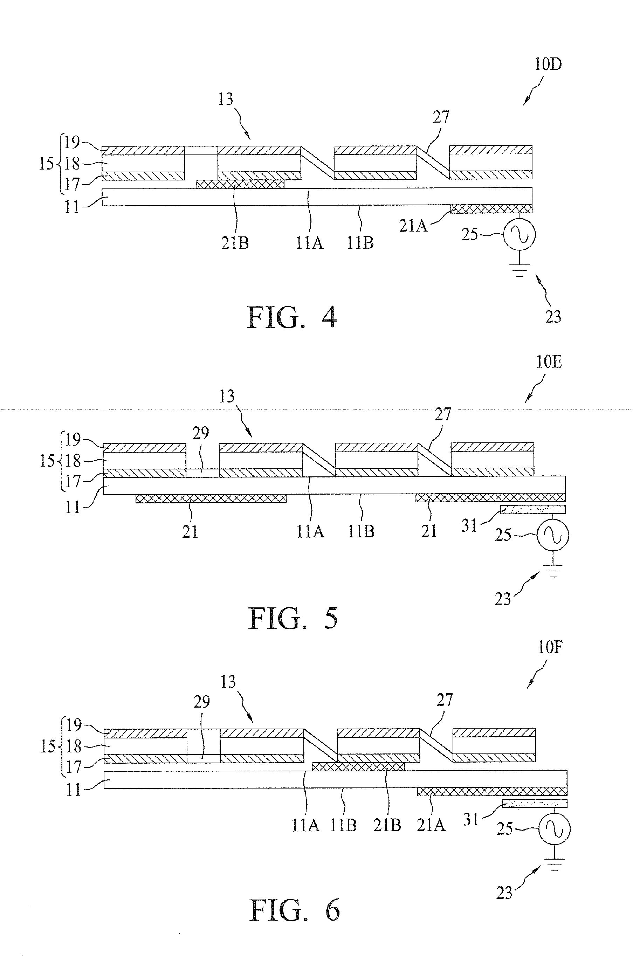

FIG. 4 illustrates an antenna structure 10D according to another embodiment of the present application. A first load metal sheet 21A and a second load metal sheet 21B of the antenna structure 10D are positioned respectively on the second surface 11B and the first surface 11A; that is, the first load metal sheet 21A is disposed on the second surface 11B, and the second load metal sheet 21B is disposed on the first surface 11A. This arrangement is in contrast to the antenna structure 10A shown in FIG. 1, in which the load metal sheet 21 of the antenna structure 10A is positioned on the second surface 11B.

FIG. 5 illustrates an antenna structure 10E according to another embodiment of the present application. The excitation source 25 in the antenna structure 10E is connected to a coupling metal sheet 31, and the coupling metal sheet 31 couples the electromagnetic power to the load metal sheet 21. This arrangement is in contrast to the antenna structure 10A shown in FIG. 1, in which the excitation source 25 of the antenna structure 10A is connected to the load metal sheet 21.

FIG. 6 illustrates an antenna structure 10F according to another embodiment of the present application. A first load metal sheet 21 A and a second load metal sheet 21 B of the antenna structure 10F are positioned respectively on the second surface 11B and the first surface 11A; that is, the first load metal sheet 21A is disposed on the second surface 11B, and the second load metal sheet 21B is disposed on the first surface 11A. This arrangement is in contrast to the antenna structure 10E shown in FIG. 5, in which the load metal sheet 21 of the antenna structure 10E is positioned on the second surface 11B.

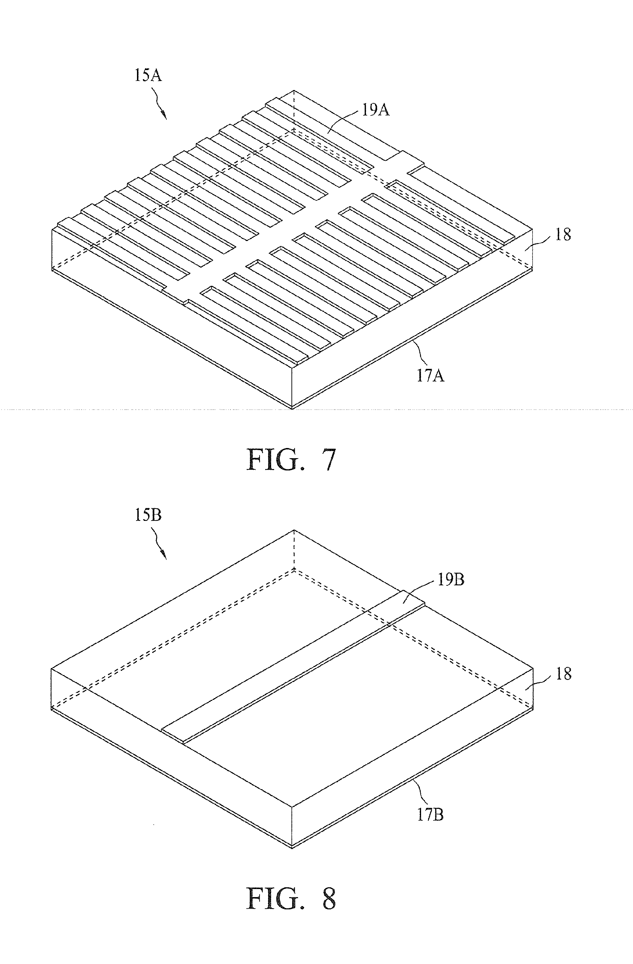

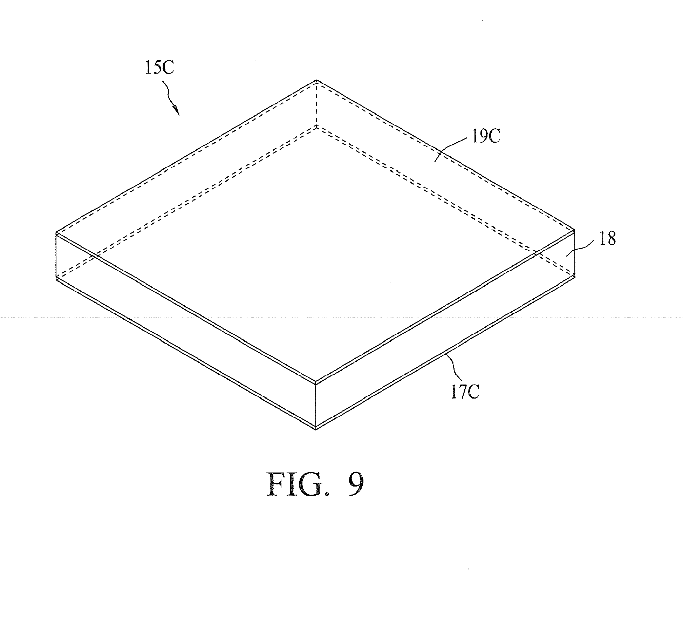

FIG. 7 illustrates the structure of a conductor unit 15A according to one embodiment of the present application. The bottom surface of the intervening materials 18 is covered by the bottom conductor 17A of the conductor unit 15A, and the top conductor 19A of the conductor unit 15A is arranged in a herringbone shape. FIG. 8 illustrates the structure of a conductor unit 15B according to another embodiment of the present application. The bottom surface of the intervening materials 18 is covered by the bottom conductor 17B of the conductor unit 15B, and the top conductor 19B of the conductor unit 15B is in a strip shape. FIG. 9 illustrates the structure of a conductor unit 15C according to another embodiment of the present application. The bottom surface of the intervening materials 18 is covered by the bottom conductor 17C of the conductor unit 15C, and the top surface of the intervening materials 18 is covered by the upper conductor 19C of the conductor unit 15C.

FIG. 10 is a 3-dimensional diagram illustrating an antenna structure 10G according to one embodiment of the present application. The ground metal sheet 23 of the antenna structure 10G is positioned on the first surface 11A, i.e. the bottom surface, of the substrate 11; the array of the conductor units 13 is also disposed on the first surface 11A of the substrate 11, wherein the ground metal sheet 23 and the array of the conductor units 13 do not overlap. In one embodiment of the present application, the load metal sheet 21 of the antenna structure 10G is comb-shaped and positioned on the second surface 11B, i.e. the upper surface, of the substrate 11, wherein the load metal sheet 21 and the array of the conductor units 13 are overlapped.

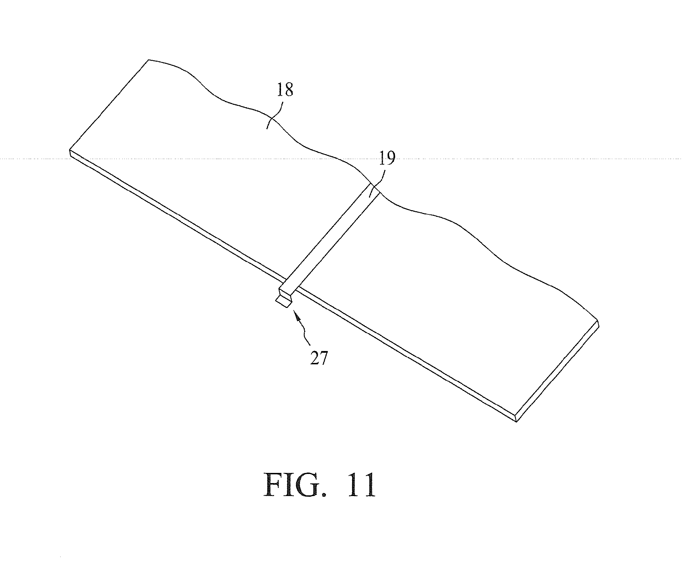

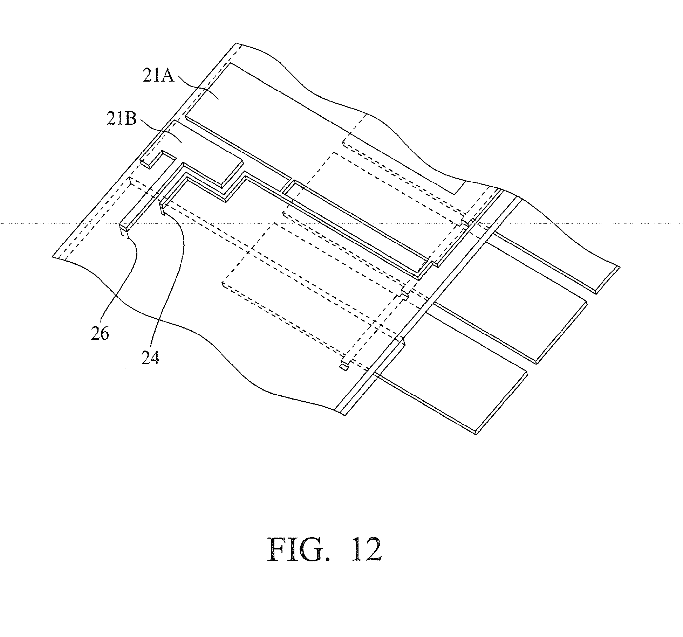

FIG. 11 is a local enlargement of the antenna structure 10G shown in FIG. 10, showing the conducting piece 27 of the array of the conductor units 13. FIG. 12 is a local enlargement of the antenna structure 10G shown in FIG. 10, showing the short circuit point 24 and the feed point 26 of the antenna structure 10G. In one embodiment of the present application, the load metal sheet 12 comprises a first load metal sheet 21A and a plurality of the second load metal sheets 21B. The short circuit point 24 penetrates through the substrate 11 and connects the first load metal sheet 21 A and the ground metal sheet 23. The feed point 26 penetrates through the substrate 11 and connects the second load metal sheet 21B and the ground metal sheet 23.

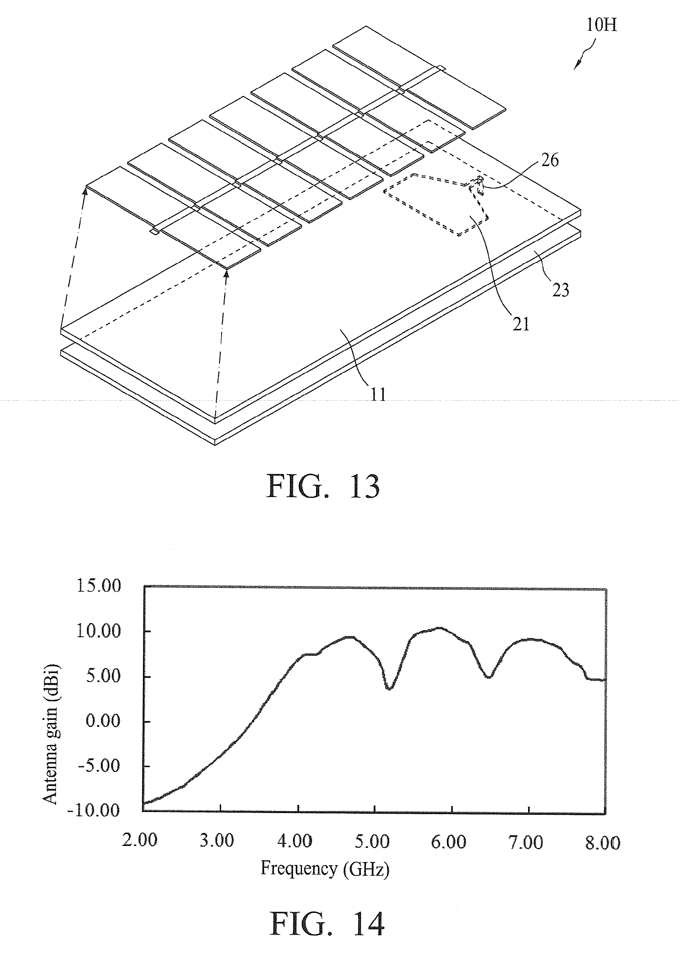

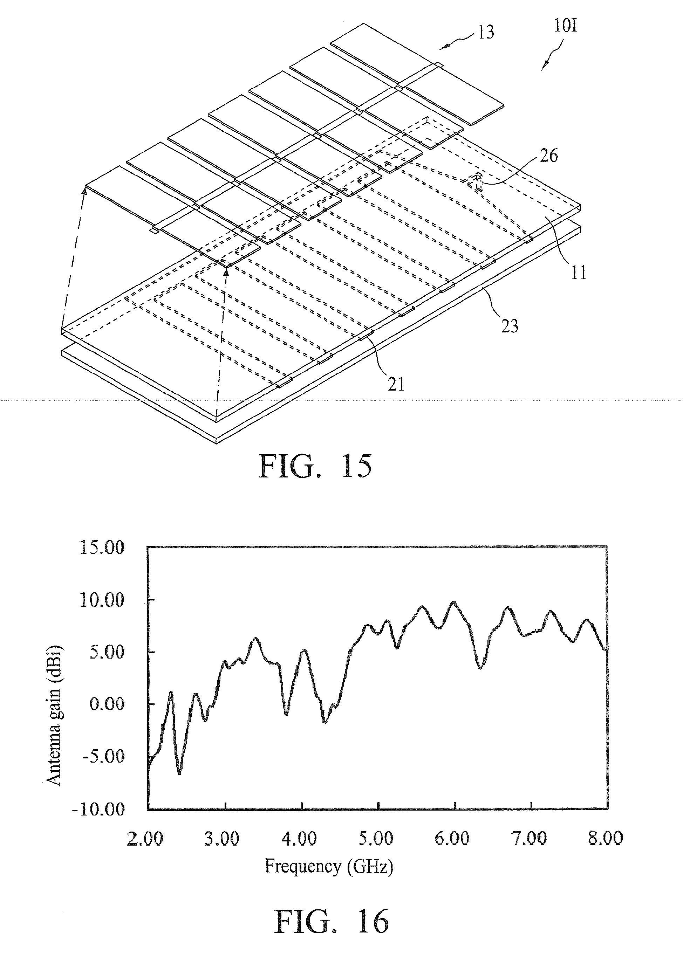

FIG. 13 illustrates an antenna structure 10H according to another embodiment of the present application. FIG. 14 illustrates a simulation diagram of the antenna gain versus frequency derived from the antenna structure 10H. FIG. 15 illustrates an antenna structure 10I according to another embodiment of the present application. FIG. 16 illustrates a simulation diagram of the antenna gain versus frequency derived from the antenna structure 10I. The load metal sheet 21 in the antenna structure 10H is trapezoid-shaped; in contrast, the load metal sheet 21 of the antenna structure 10I is comb-shaped.

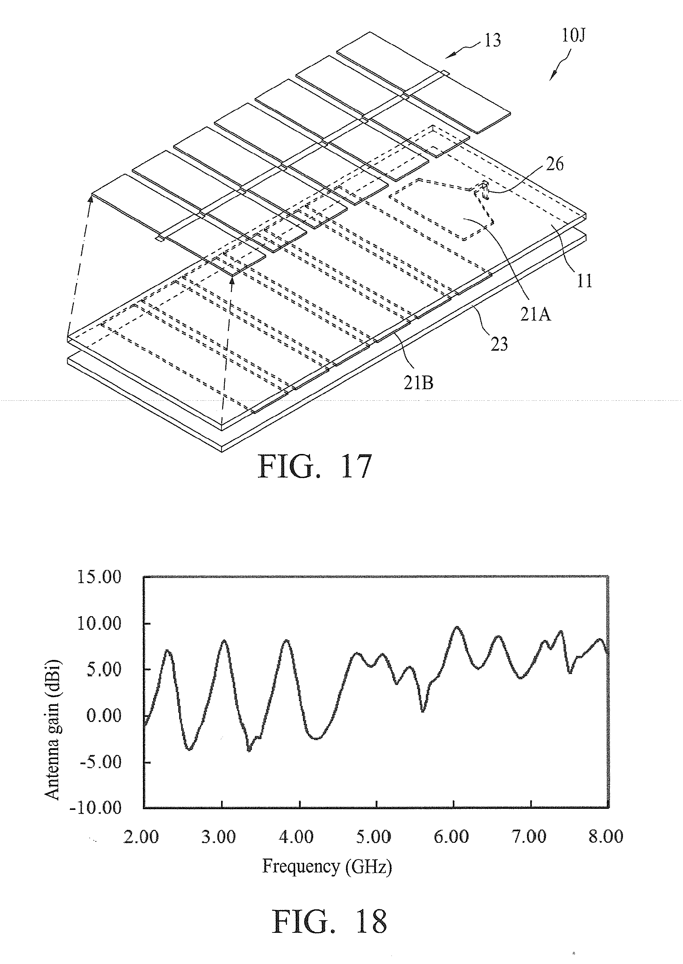

FIG. 17 illustrates an antenna structure 10J according to another embodiment of the present application. FIG. 18 illustrates a simulation diagram of the antenna gain versus frequency derived from the antenna structure 10J. The antenna structure 10J comprises a first load metal sheet 21A and a plurality of the second load metal sheets 21 B, wherein the feed point 26 is connected to the first load metal sheet 21A.

Referring to the simulation diagram of the antenna gain derived from the antenna structure 10H (FIG. 14), the simulation diagram of the antenna gain derived from the antenna structure 10I (FIG. 16), and the simulation diagram of the antenna gain derived from the antenna structure 10J (FIG. 18), different arrangements of the load metal sheet 21 on the array of the conductor unit 13 of a same size results in different electromagnetic power coupling due to different parasitic effects. Increase of the occupying area of the load metal sheet 21B provides current paths for radio frequency, hence the antenna structure 10J can operate at lower frequency ranges than the antenna structure 10H.

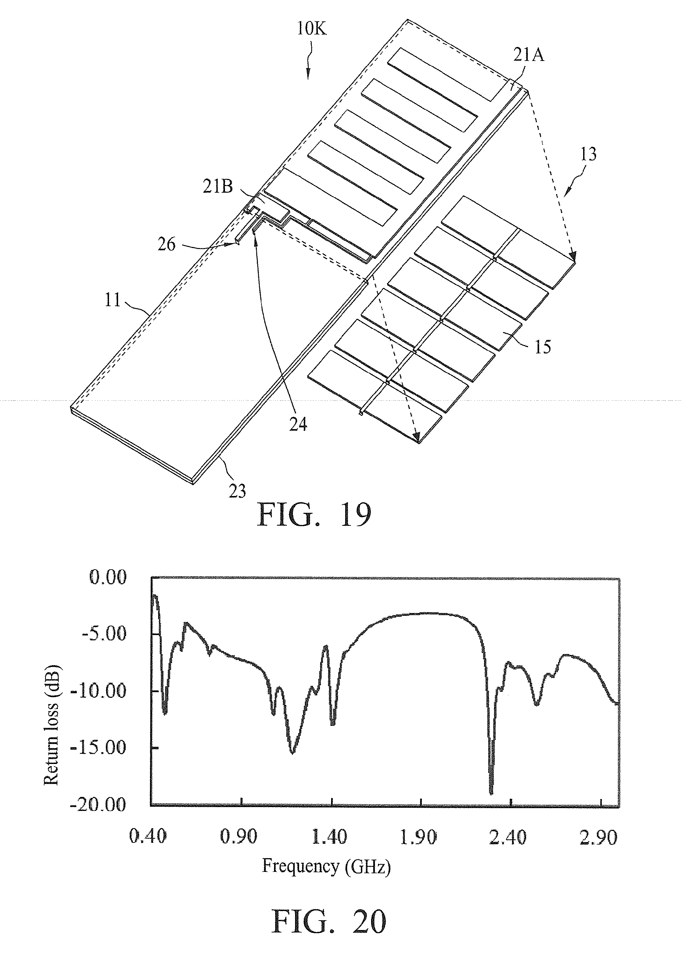

FIG. 19 illustrates an antenna structure 10K according to another embodiment of the present application. FIG. 20 illustrates a simulation diagram of the return loss derived from the antenna structure 10K. The ground metal sheet 23 and the array of the conductor units 13 are positioned on the same surface of the antenna structure 10K, and do not overlap each other. The first load metal sheet 21A and the second load metal sheet 21B are positioned on the same surface of the substrate, and the array of the conductor units 13 is positioned on another surface of the substrate. The first load metal sheet 21 A is branch-shaped. The short circuit point 24 penetrates through the substrate 11 and connects the first load metal sheet 21A and the ground metal sheet 23. The feed point 26 penetrates through the substrate 11 and connects the second load metal sheet 21 B and the ground metal sheet 23.

Referring to the simulation diagram of the return loss in FIG. 20, the corresponding antenna structure 10K has a return loss smaller than -7dB within a frequency range of from 0.5 to 1.0 GHz. This shows the power of the excitation source 25 can be fed to the antenna structure 10K within that specific frequency range. In other words, the antenna structure 10K shown in FIG. 19 can operate GSM900 and digital television frequency signals. In addition, the operating frequency of the next generation of the wireless communication system, LTE (Long Term Evolution), may include a frequency range of from 2.3 to 2.69 GHz. Referring to the simulation diagram of the return loss in FIG. 20, the corresponding antenna structure 10K has a return loss smaller than -7dB within a frequency range of from 2.3 to 2.69 GHz. This shows the power of the excitation source 25 can be fed to the antenna structure 10K within that specific frequency range. In other words, the antenna structure 10K shown in FIG. 19 is also suitable for application to the future LTE wireless communication system.

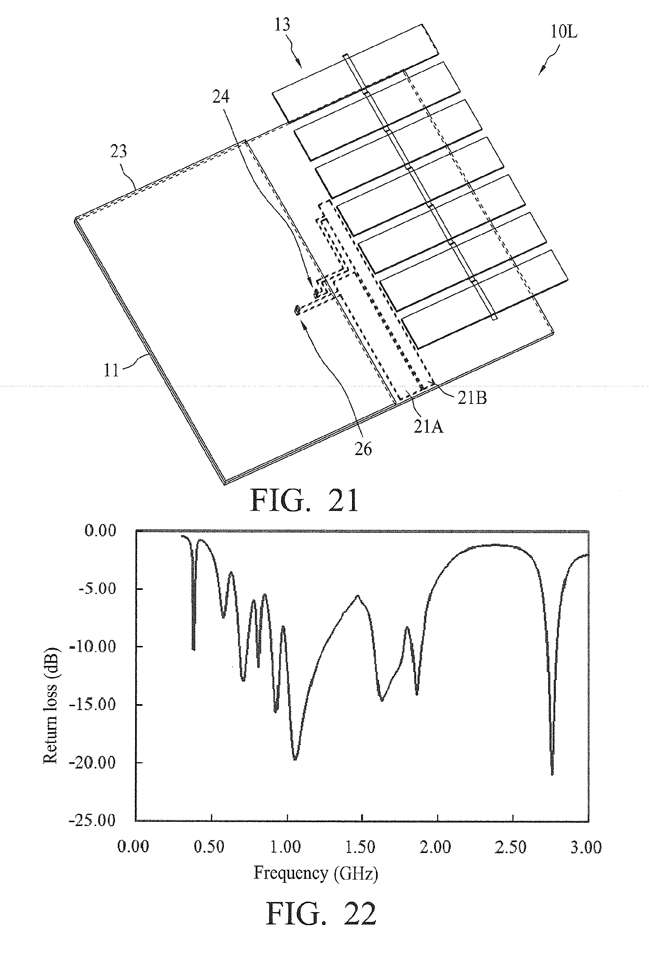

FIG. 21 illustrates an antenna structure 10L according to another embodiment of the present application. FIG. 22 illustrates a simulation diagram of the return loss derived from the antenna structure 10L. The ground metal sheet 23 and the array of the conductor units 13 are positioned on the same surface, but do not overlap each other. The antenna structure 10L includes a first load metal sheet 21 A and a second load metal sheet 21B. The short circuit point 24 penetrates the substrate 11 and connects the first load metal sheet 2 1 B and the ground metal sheet 23. The feed point 26 penetrates the substrate 11 and connects the second load metal sheet 21 A and the ground metal sheet 23.

Referring to the simulation diagram of the return loss in FIG. 22, the corresponding antenna structure 10L has a return loss smaller than -7dB within a frequency range of from 0.5 to 1.0 GHz, and the specific frequency range covers the frequency of the GSM 850/900 communication system and the digital television system. This shows a major portion of the power of the excitation source 25 can be fed to the antenna structure 10L within that specific frequency range. In other words, the antenna structure 10L shown in FIG. 21 can operate GSM900 and/or digital television frequency signal.

In addition, the operating frequency of the GSM1800 communication system is within a frequency range of from 1.6 to 2.0 GHz. Referring to the simulation diagram of the return loss in FIG. 22, the corresponding antenna structure 10L has a return loss smaller than -7dB within a frequency range of from 1.6 to 2.0 GHz. This shows the power of the excitation source 25 can be fed to the antenna structure 10L within that specific frequency range. In other words, the antenna structure 10L shown in FIG. 21 is also suitable for the application in the GSM1800 communication system.

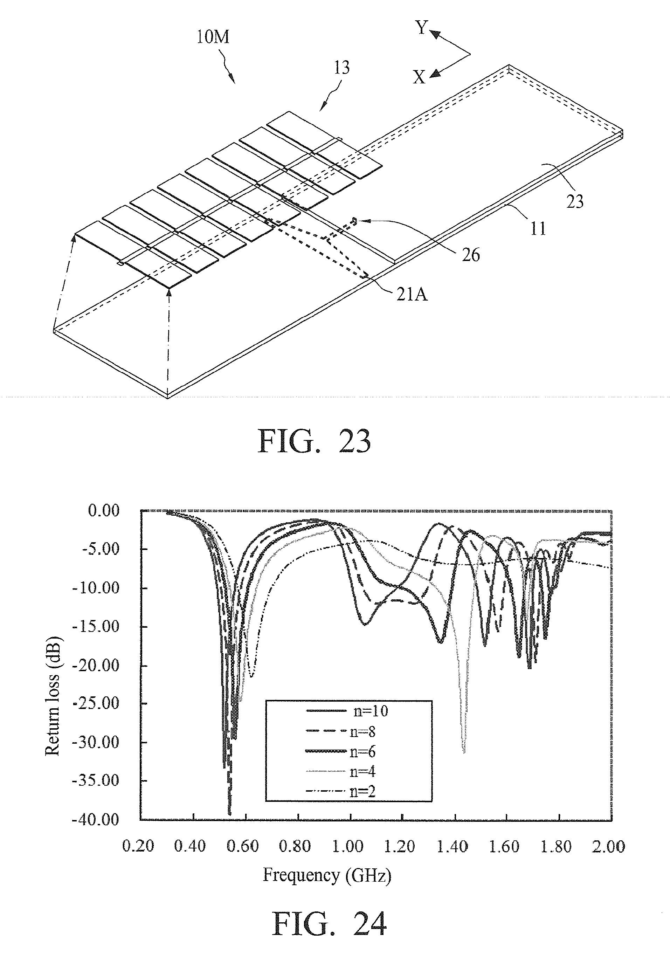

FIG. 23 illustrates an antenna structure 10M according to another embodiment of the present application. FIG. 24 illustrates a simulation diagram of the return loss derived from the antenna structure 10M, wherein the number (n) of conductor units 15 in the antenna structure 10M is 2, 4, 6, 8 and 10. As shown in FIG. 24, the waveform diagram of the return loss changes with a different number of conductor units 15. In other words, the antenna structure 10M in the present application can modulate the return loss by changing the number of conductor units 15 and by changing the operating frequency.

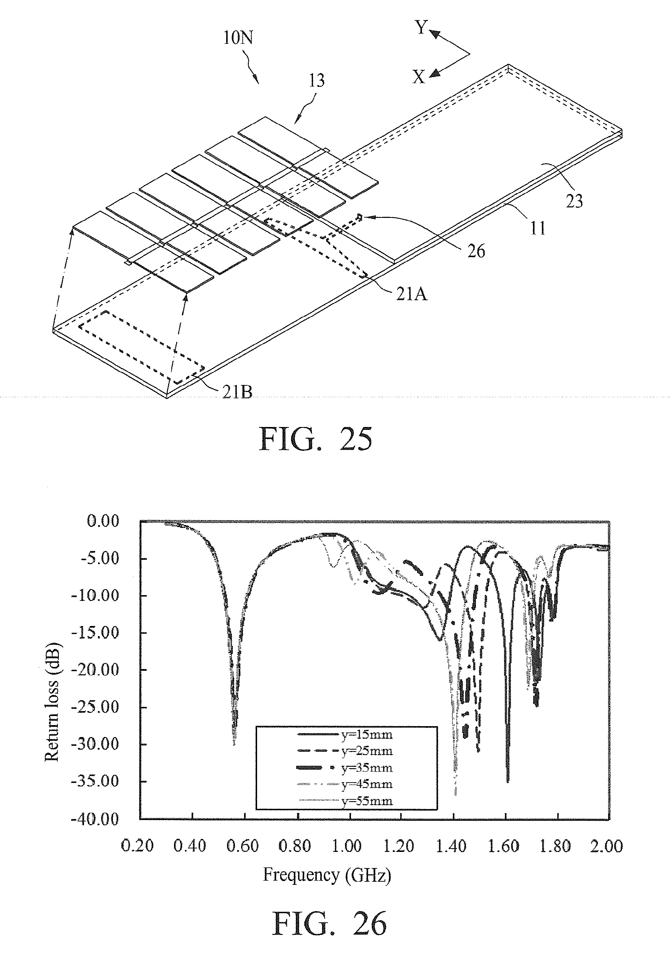

FIG. 25 illustrates an antenna structure 10N according to another embodiment of the present application. FIG. 26 illustrates a simulation diagram of the return loss derived from the antenna structure ION. The antenna structure 10N comprises a first load metal sheet 21A and a second load metal sheet 21B. The first load metal sheet 21A is coupled to the feed point 26. The second load metal sheet 2 1 B has a fixed width in the X direction, and variable widths of 15mm, 25mm, 35mm, 45mm, and 55mm in the Y direction. As shown in FIG. 26, the frequency response of the antenna structure 10N changes with the Y direction width of the second load metal sheet 21B. In other words, the antenna structure 10N in the present application can modulate the return loss by changing the Y direction width of the second load metal sheet 21B, so as to change the operating frequency.

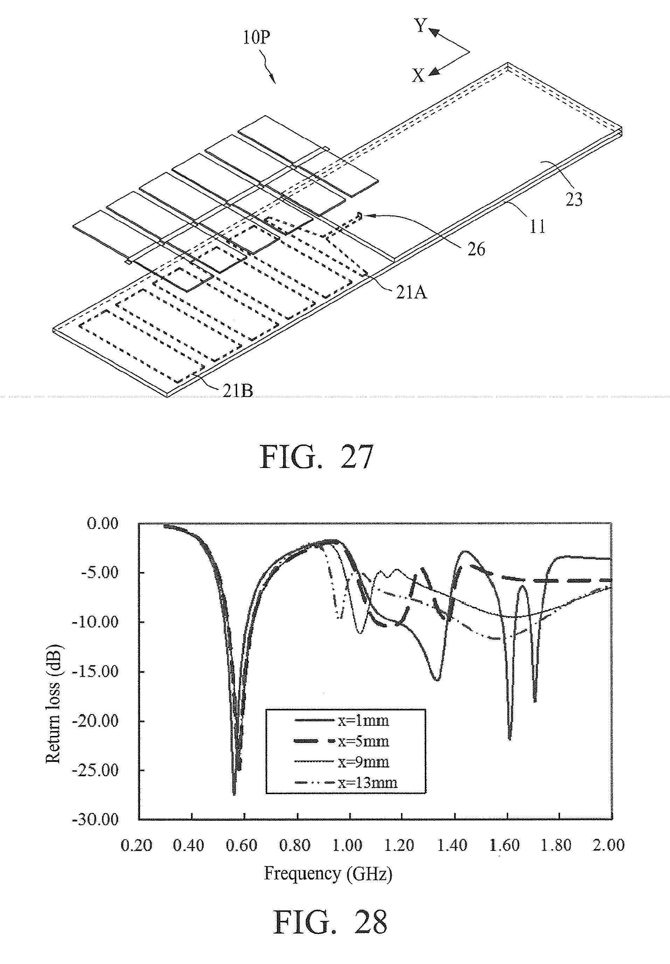

FIG. 27 illustrates an antenna structure 10P according to another embodiment of the present application. FIG. 28 illustrates a simulation diagram of the return loss derived from the antenna structure 10P. The antenna structure 10P comprises a first load metal sheet 21A and a plurality of second load metal sheets 21B, wherein the first load metal sheet 21 A is coupled to the feed point 26. The second load metal sheet 21B has a fixed width in the Y direction, and variable widths of 1mm, 5mm, 9mm, and 13mm in the X direction. As shown in FIG. 28, the frequency response of the antenna structure 10P changes with the X direction width of the second load metal sheet 21B. In other words, the antenna structure 10P in the present application can modulate the return loss by changing the X direction width of the second load metal sheet 21B, so as to change the operating frequency.

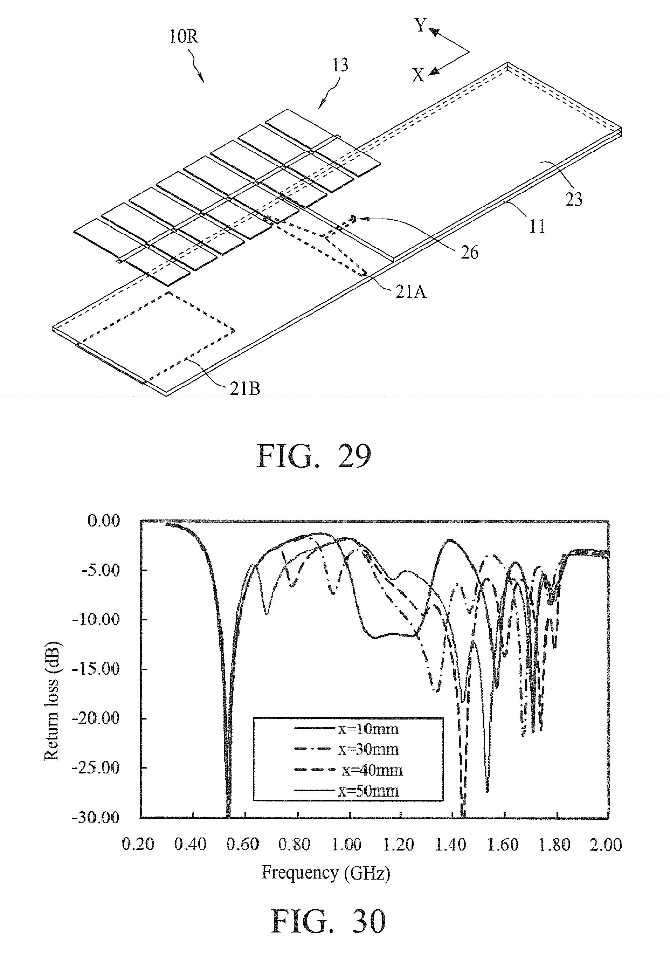

FIG. 29 illustrates an antenna structure 10R according to another embodiment of the present application. FIG. 30 illustrates a simulation diagram of the return loss derived from the antenna structure 10R. The antenna structure 10R comprises a first load metal sheet 21 A and a second load metal sheet 21B, wherein the first load metal sheet 21A is coupled to the feed point 26. The second load metal sheet 21B has a fixed width in the Y direction, and variable widths of 10mm, 30mm, 40mm, and 50mm in the X direction. As shown in FIG. 30, the frequency response of the antenna structure 10R changes with the X direction width of the second load metal sheet 21B. In other words, the antenna structure 10R in the present application can tune the return loss by changing the X direction width of the second load metal sheet 21B, so as to change the operating frequency.

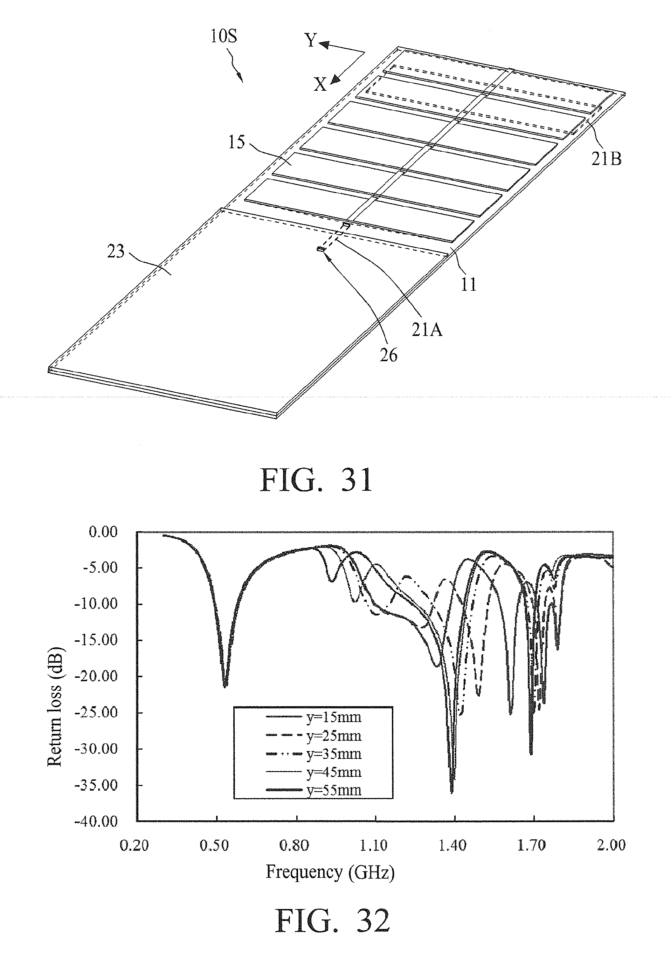

FIG. 31 illustrates an antenna structure 10S according to another embodiment of the present application. FIG. 32 illustrates a simulation diagram of the return loss derived from the antenna structure 10S. The antenna structure 10S comprises a first load metal sheet 21A and a second load metal sheet 21B. The antenna structure 10N is shown in FIG. 25, wherein the feed point 26 is coupled to the first load meal sheet 21A and the ground metal sheet 23. The conductor of the conductor unit 15 is not in contact with the first load metal sheet 21A and is configured to be DC open. This arrangement is in contrast to the antenna structure 10S shown in FIG. 31, wherein the feed point 26 is coupled to the second load meal sheet 21A and the ground metal sheet 23. The conductor of the conductor unit 15 is in contact with the second load metal sheet 21A and is configured to be DC short. Comparing FIG. 26 (the return loss diagram of the antenna structure 10N shown in FIG. 25) and FIG. 32 (the return loss diagram of the antenna structure 10S shown in FIG. 31), the operating frequency of the antenna structure 10S in the present application can be altered by changing the configuration, namely coupling or direct contact, of electromagnetic wave feeding.

In addition, the load metal sheet 21 of the antenna structure 10S has a fixed width 16mm in the X direction, and variable widths of 15mm, 25mm, 35mm, 45mm, and 55mm in the Y direction. As shown in FIG. 32, the return loss of the antenna structure 10S changes with the Y direction width of the second load metal sheet 21 B. In other words, the antenna structure 10S in the present application can tune the frequency response by changing the Y direction width of the second load metal sheet 21B, so as to change the operating frequency.

Summing up, the present application discloses an antenna structure with multiple conductor units. An array of conductor units are formed by arranging multiple conductor units in a predetermined area and electrically connecting each conductor unit via electrical coupling or magnetic coupling, so as to excite radiation modes within specific frequency ranges. In addition, the present application discloses antenna structures which are able to receive and emit the desired radio frequency wave by utilizing the parasitic effect between the array of conductor units and load metal sheets, and the coupling of electromagnetic power between each conductor units, so as to generate radiation modes in specific frequencies. Moreover, due to the structural similarity between the conductor unit and a photovoltaic conversion unit, the photovoltaic conversion unit in the present application can be properly arranged into an antenna structure with multiple conductor units. The antenna structure is able to emit radiation modes in a specific frequency but will not affect the conversion efficiency of the photovoltaic conversion unit.

Although the present application and its advantages have been described in detail, it should be understood that various changes, substitutions and alterations can be made herein without departing from the spirit and scope of the application as defined by the appended claims. For example, many of the processes discussed above can be implemented in different methodologies and replaced by other processes, or a combination thereof.

Moreover, the scope of the present application is not intended to be limited to the particular embodiments of the process, machine, manufacture, composition of matter, means, methods and steps described in the specification. As one of ordinary skill in the art will readily appreciate from the disclosure of the present application, processes, machines, manufacture, compositions of matter, means, methods, or steps, presently existing or later to be developed, that perform substantially the same function or achieve substantially the same result as the corresponding embodiments described herein may be utilized according to the present application. Accordingly, the appended claims are intended to include within their scope such processes, machines, manufacture, compositions of matter, means, methods, or steps.

## Claims

1. An antenna structure, comprising:
a substrate having a first surface and a second surface;
an array of conductor units positioned on the first surface and including at least two conductor units which are coupled, wherein each conductor unit includes an intervening material and two conductors, and the two conductors are positioned on opposite surfaces of the intervening material; and
at least one load metal sheet positioned on the first surface, on the second surface, or on the first surface and the second surface.

2. The antenna structure of Claim 1, wherein an excitation source is connected between the conductor unit and a ground metal sheet.

3. The antenna structure of Claim 1, wherein an excitation source is connected between one of the at least one load metal sheet and a ground metal sheet.

4. The antenna structure of any of the preceding claims, further comprising a coupling metal sheet coupling electromagnetic power to the at least one load metal sheet, wherein an excitation source is connected between the coupling metal sheet and a ground metal sheet.

5. The antenna structure of any of the preceding claims, wherein the partial portion of the at least one load metal sheet can overlap the vertical projection of the gap between conductor units.

6. The antenna structure of any of the preceding claims, wherein the conductor units are photovoltaic conversion units.

7. The antenna structure of any of the preceding claims, wherein one or more of the at least one load metal sheet is positioned on the first surface and configured to be DC short with the conductor of the conductor unit.

8. The antenna structure of any of the preceding claims, wherein the at least one load metal sheet is positioned on the second surface and configured to be DC open with the conductor of the conductor unit.
